Europäisches Patentamt

European Patent Office

Office européen des brevets

(19)

(11) Publication number: **0 402 482**

**A1**

(12) **EUROPEAN PATENT APPLICATION**
**published in accordance with Art.**
**158(3) EPC**

(21) Application number: **90900997.9**

(51) Int. Cl.5: **H01L 21/302**

(22) Date of filing: **15.12.89**

(86) International application number:
**PCT/JP89/01260**

(87) International publication number:
**WO 90/07790 (12.07.90 90/16)**

(30) Priority: **28.12.88 JP 331809/88**

(43) Date of publication of application:
**19.12.90 Bulletin 90/51**

(84) Designated Contracting States:
**DE FR GB NL**

(71) Applicant: **Oki Electric Industry Company,**
**Limited**
**7-12, Toranomon 1-chome Minato-ku**
**Tokyo 105(JP)**

(72) Inventor: **UCHIYAMA, Akira Oki Electric**
**Industry Co., Ltd.**
**7-12, Toranomon 1-chome Minato-ku**
**Tokyo 105(JP)**
Inventor: **IWABUCHI, T. Oki Electric Ind. Co.,**
**Ltd.**
**7-12, To-ranomon 1-chome, Minato-ku**
**Tokyo 105(JP)**

(74) Representative: **Betten & Resch**
**Reichenbachstrasse 19**
**D-8000 München 5(DE)**

(54) **METHOD OF FORMING PATTERN.**

(57) A film (55) for patterning is formed on the whole surface of a side of a substrate (53) that has a recess, and then the film (55) is selectively removed by anisotropic etching. Hence, only the film (55) on the side wall (51a) remains intact. When the portions of the material film (55) remaining on the side walls (51a) are selectively removed by anisotropic etching from above the substrate (53), the material film (55) can be patterned in accordance with the size defined by the upper portion of a mask layer, because the film (55) exists only on the side walls (51a).

*Fig. 1(B)*

SPECIFICATION

PATTERN FORMING METHOD

TITLE MODIFIED
see front page

Technical Field

This invention relates to a method for forming a pattern of a film made of a desired material on a stepped side wall of a stepped base, which pattern fomration method is appropriately used, for example, for forming a desired film pattern of good precision on a plane which intersects perpendiculary to the main plane of the base in order to achieve high integration of LSI.

BACKGROUND OF THE ART

In order to improve the degree of integration of LSI on a limited substrate area, the reduction of areas of individual semiconductor elements constituting LSI on the main plane of substrate is indispensably necessitated more and more. To this end, a technique has been employed wherein a groove is made in the substrate so that the side walls (portions corresponding to wall surfaces) are utilized as a region for forming semiconductor elements in order to increase the surface area on which the elements are to be formed. However, the side wall such as of groove has now been used, for example, only to increase an area for capacitor and has never been in use so as to form a wiring or a gate electrode for transistor. Nevertheless, the necessity for forming wirings or elements on the side wall will be demanded more and more, so that it is believed necessary to establish a method wherein patterns of a wiring or gate electrode can be readily formed.

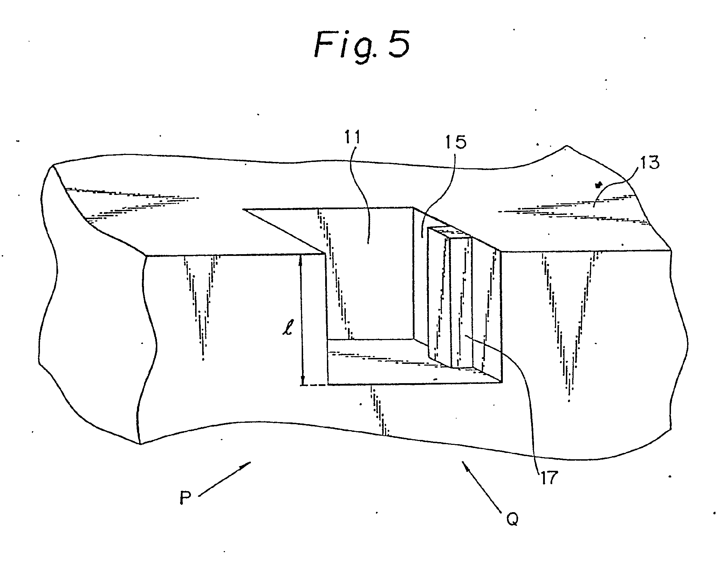

Fig. 5 is an illustrative view of an example for forming a thin film pattern on side wall, this view being a perspective view of an ideal form of a thin film pattern while part of groove is broken away in case where a semiconductor substrate 13 having a groove 11 with a depth of   is formed with a thin film patern 17 on a stepped side wall 15 constituted by the groove 11 along the depth of the groove 11.

In prior art, however, it is very difficult to form such an ideal thin film pattern 17 as shown in Fig. 5.  For instance, when using a known single layer resist process, the resultant thin film pattern becomes one which is described hereinlater.

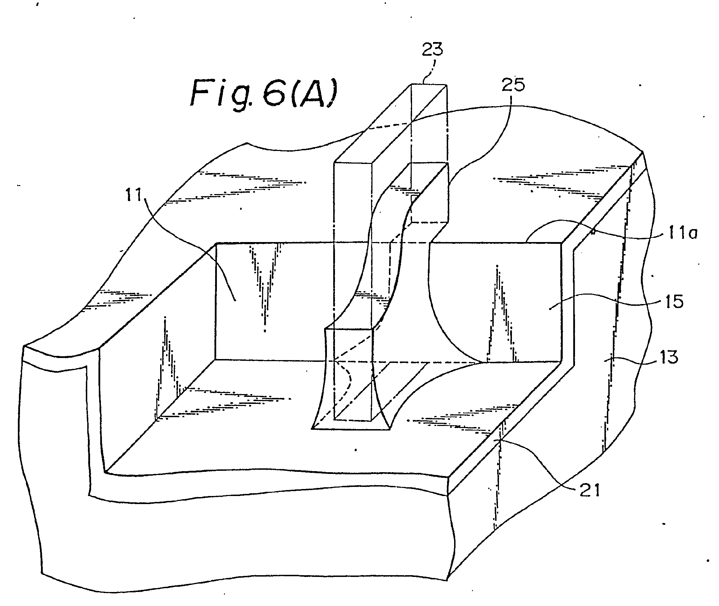

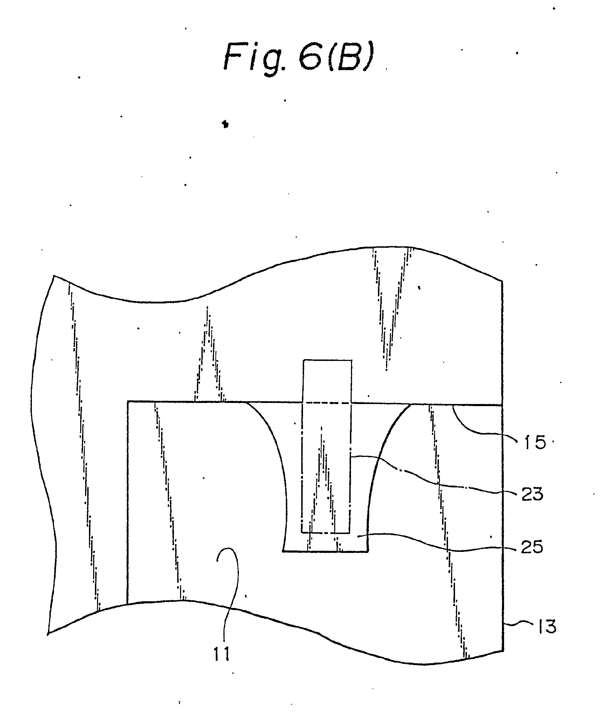

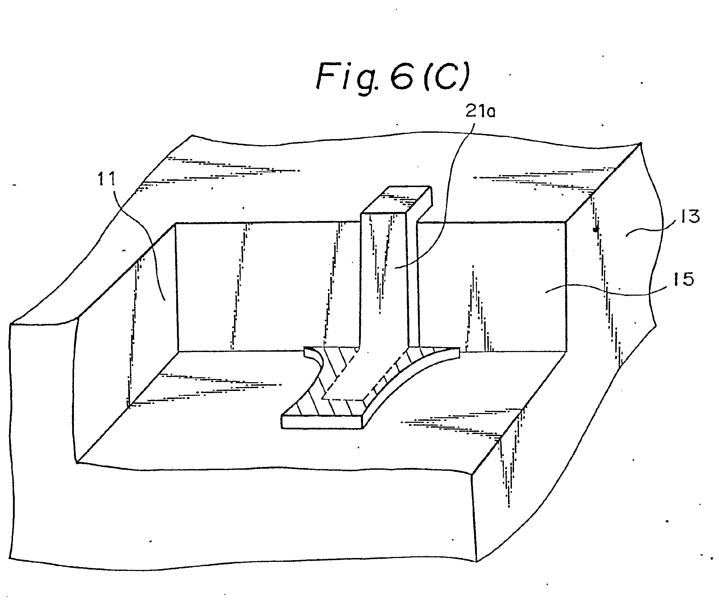

Figs. 6(A) - (C) are, respectively, illustrative views showing the sates of sample in main steps used to form a film pattern on a steppd side wall according to a pattern forming method using the known single layer reist process.  More particularly, Figs. 6(A) and (C) are, respectively, partially perspective views showing the same from a direction corresponding to the direction shown as P in Fig. 5, and Fig. 6(B) is a plan view of the sample shown in Fig. 6(A) as viewed from the above of the semicondutor substrate 11.

Where the single resist process is used, a film 21 of material used to form a thin film pattern is fomred on the surface of the semiconductor substrate 13 including the inner surfaces of the groove 11.  Next, the material film 21 is applied on the entire surface thereof, for example, with a positive resist (not shown).  Subsequently, a light-shielding mask which is provided at such a position that it crosses a boundary 11a of the step established by the groove 11 is used and the resist is exposed to light from the above of the light-shielding mask, followed by development as desired to form a resist pattern 25 on a region transversing the boundary 11a of the step of the thin film 21 (Fig. 6(A)). However, the thus formed resist pattern 25 is finished as a shape which is completely different from the shape of the light-shielding mask 23 as is particularly shown in Fig. 6(B). This is considered for the reason that the resist which has been applied onto the surface of the semiconductor substrate 13 becomes thicker in the bottom portion of the groove and particularly at the corner portions of the groove 11, so that the light for the exposure does not arrive at the lower side of the thicker resist. Accordingly, a thin film pattern 21a which is obtained by anisotropic etching, such as RIE (Reactive Ion Etching), through the resist pattern 25 as a mask from the above of the semiconductor substrate 11 has a shape which is far away from the shape of the light-shielding mask 23 used as is shown in Fig. 6(C). More particularly, a useless region as shown in Fig. 6(C) as hatched is left at the lower portion of the step.

As a measure for overcoming the drawback involved in the known single layer resist process, there was known a so-called double layer resist process disclosed, for example, in the following literature (Process Techniques For Next Generation Super LSI (Applications) (April 4, 1988), by Realize Co., Ltd., p. 297-298). In this process, after flattening the step of substrate with a first resist layer, a second reist layer is fomed on the first resist layer and is exposed to light and developed to obtain a mask. The first resist layer is subjected to patterning through the mask, thereby precisely controlling the patterned shape at the stepped portion.

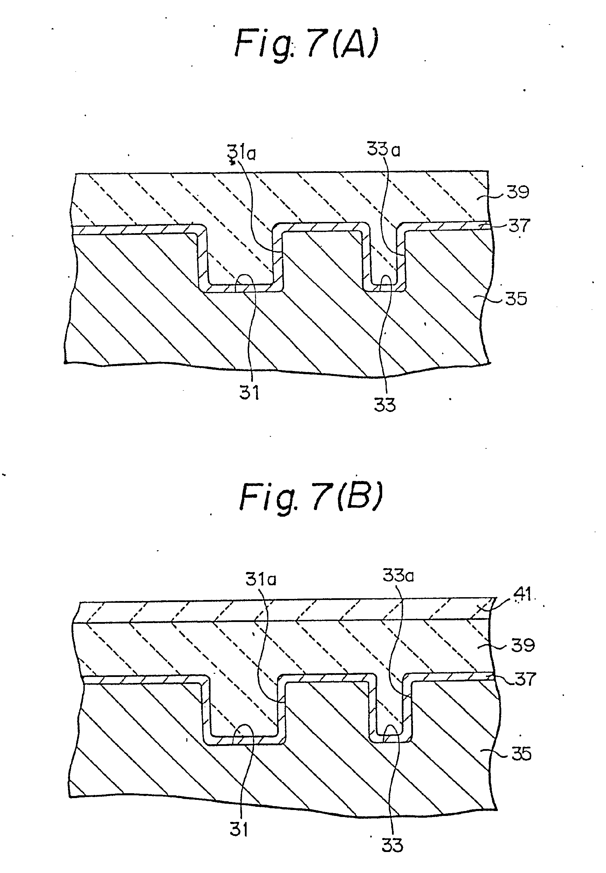

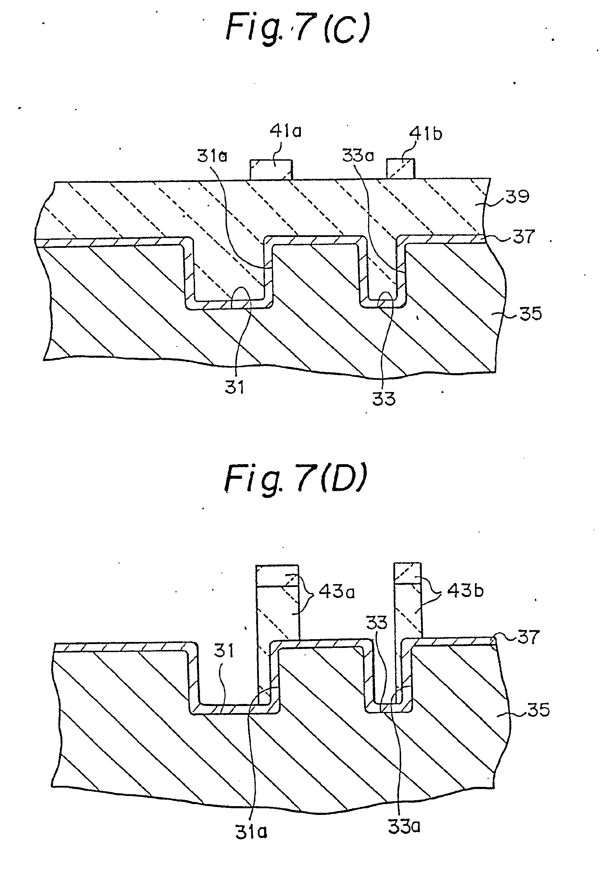

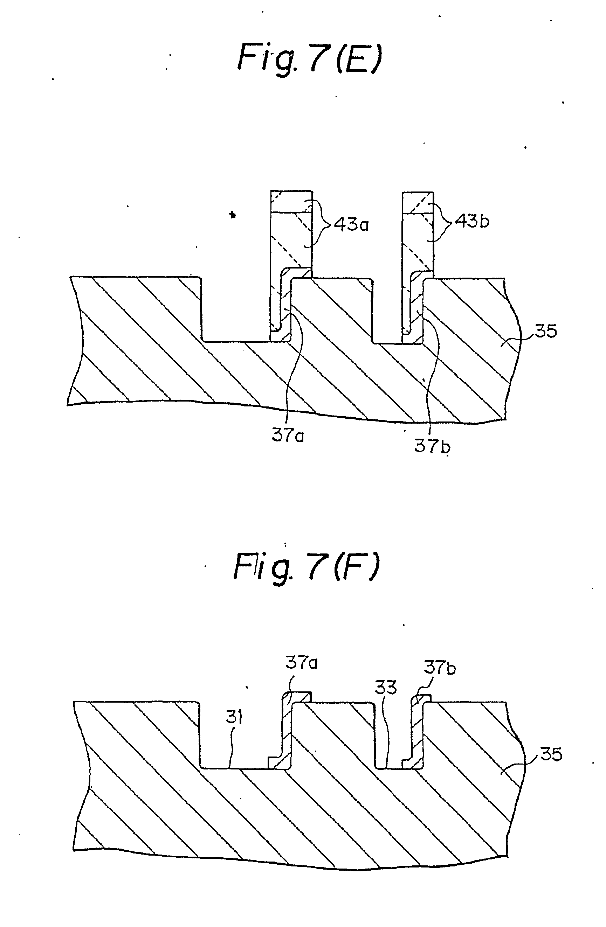

Figs. 7(A) - (F) are, respectively, illustrative views showing the principle of the double layer resist process wherein there are shown steps of forming a film pattern according to the double layer resist process on stepped side walls 31a, 33a of two

recesses 31, 33 of a semiconductor substate 35, respectively. All the figures are a sectional view of the semiconductor substrate 35 which is cut away along the direction intersecting with the side walls 31a, 33a.

Initially, a film 37 of material for the formation of film pattern is formed on the entire surface of the semiconductor substrate 35 having the recesses 31, 33, on which a first thick resist layer 39 is further formed in order to flatten the surface (Fig. 7(A)).

Then, a second resist layer 41 is formed on the first resist layer 39 (Fig. 7(B)), after which the second resist layer 41 is subjected to exposure to light in a desired pattern and developed to form resist patterns 41a, 41b (Fig. 7(C)).

Subsequently, the first resist layer 39 is subjected to patterning such as by dry etching through the mask of the resist patterns 41a, 41b to form the double layer resist patterns 43a, 43b (Fig. 7(D)).

The double layer resist patterns 43a, 43b are used as a mask for patterning of the material film 37 so that portions containing the respective side walls 31a, 33a in the recesses 31, 33 are left (Fig. 7(E)).

Then, the double layer resist patterns 43a, 43b are removed to eventually obtain desired film patterns 37a, 37b (Fig. 7(F)).

According to the double layer resist process, the flattening layer (first resist layer) and the layer for exposure to light and development (second reist layer) are provided separately, so that a pattern shape faithful to the exposure mask can be obtained even at the stepped portion.

However, the double layer resist process has the problem that the procedure is complicated. As will be apparent from the

4

process illustrated with reference to Figs. 7(A) - (F), the double layer resist process has additional steps including the step of applying the first resist layer and the step of the patterning of the first resist layer as campared with the single layer resist process. Moreover, although omitted in the above description, the double layer resist process inevitably requires a baking step after the application of the first resist layer and prior to the application of the second resist layer, wherein heat is applied to the first resist layer for drying.

In addition, when the first resist layer is anisotropically etched, the second resist layer should have a satisfactory etching selection ratio to the first resist layer, thus presenting a problem that the selection of material is difficult.

The complicated process and the reduction in degree of freedom with respect to the selection of resist material are not favorable, for example, in view of the direct rise of the production costs of the semiconductor device.

Both the known single layer resist process and the known double layer resist process are impossible in that the film pattern is left only on the side wall or walls of the step (e.g. the film pattern 17 is left only on the side wall as shown in Fig. 5), with an attendant problem that the film pattern also remains on the upper and lower portions of the step. This is because in the prior processes, after the material film has been formed on the entire surface of the substrate including the step, a resist pattern is formed on the material film so as to cover the stepped side wall. More particularly, in order to reliably cover the stepped side wall with the resist pattern, the shift in mask alignment beween the mask used to form the resist pattern (the light-shielding mask as in Fig. 6(A)) and the stepped side wall has to be taken into account. Accordingly, the light-shielding mask as in Fig. 6(A) and the stepped side wall has to be taken into account. Accordingly, the light-shielding mask 23 is inevitably so formed as shown in Fig. 6(A) wherein it extends over the upper and lower portions of the step while covering the step therewith. Since the material film 21 is formed on the entire surface of the substrate, the film pattern 21a will be left on the upper and lower portions of the step as corresponding to the additional regions required for the mask alighment. This phenomenon takes place in the double layer resist process illustrated with reference to Fig. 7.

The present invention has been accomplished in view of the situation stated above and has for its object the dissolution of the above problems and the provision of a method wherein a desired pattern can be simply formed on a side wall or walls of step.


DISCLOSUE OF THE INVENTION

According to the invention, after formatin of a film of material used to form a film pattern on the entire surface of a base having a step therein, the material film is initially removed by anisotropic etching except for a side wall or walls of the step. Accordingly, even if a mask layer is formed to extend over upper and lower portions of the step while taking into account an allowance for mask alignment, the material film will not be left at the upper and lower portions of the step because of the absence of the material film on these upper and lower portions.

When the portion of the material left on the side wall is selectively removed by anisotropic etching from the above of the base surface (i.e. from the direction parallel to the side wall), the material film which has been provided only on the side wall of the step is patterned to dimensions regulated according to the dimensions of the mask layer on the upper portion of the step even though the resist pattern at the lower portion of the step is completely different from a desired one.


## BRIEF DESCRIPTION OF THE DRAWINGS

Figs. 1(A) - (G) are a flow chart for illustrating a pattern formation method according to one embodiment of the invention;

Figs. 2(A) and (B) are illustrative views of another embodiment of a pattern formation method of the invention;

Figs. 3(A) and (B) are, respectively, illustrative views of an application of a pattern formation method of the invention;

Fig. 4 is an illustrative view of another application of a pattern formation method of the invention;

Fig. 5 is an illustrative view of the prior art invention; and

Figs. 6(A) - (C) and Figs. 7(A) - (F) are, respectively, illustrative views of prior art processes.


## BEST MODE FOR CARRYING OUT THE INVENTION

The pattern formation method of the invention is described with reference to the accompanying drawings. It will be noted that in the description of the following embodiments, a stepped base is illustrated as a semiconductor substrate and thus, the invention is applied for fabricating a semiconductor device only for illustration. In this connection, the invention can be widely applied to fields other than that of semiconductor device if it is intended to form a pattern on a side wall or walls of step. It should also be noted that the figures used for illustration are those which are schematically shown to an extent that the invention is understandable and that the dimensions, shapes, positional relations and dimensional ratios of the respective members are not precise. Hence, the present invention should not be construed as being limited only to these embodiments shown in the figures.

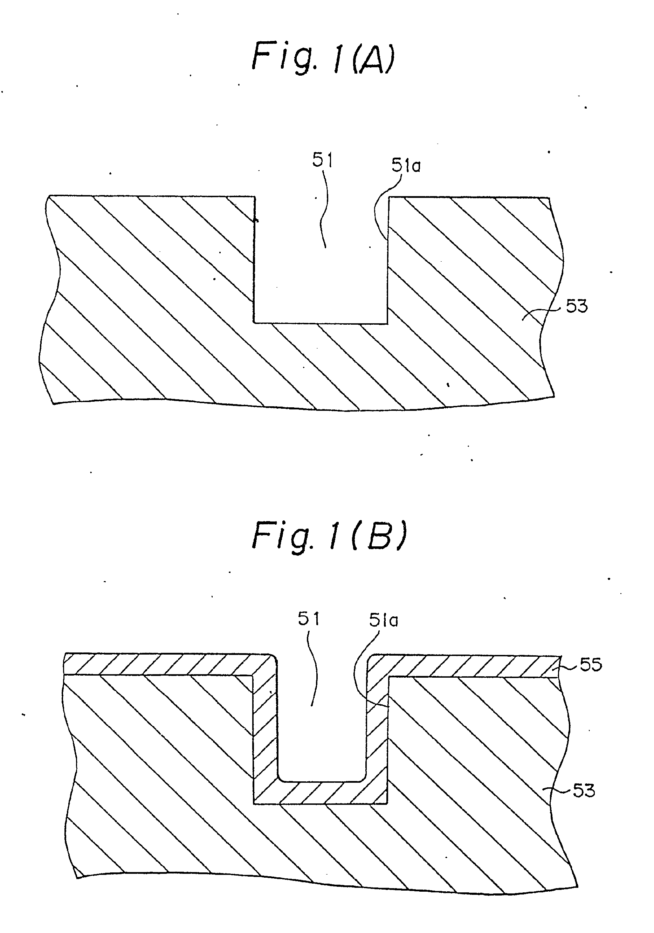

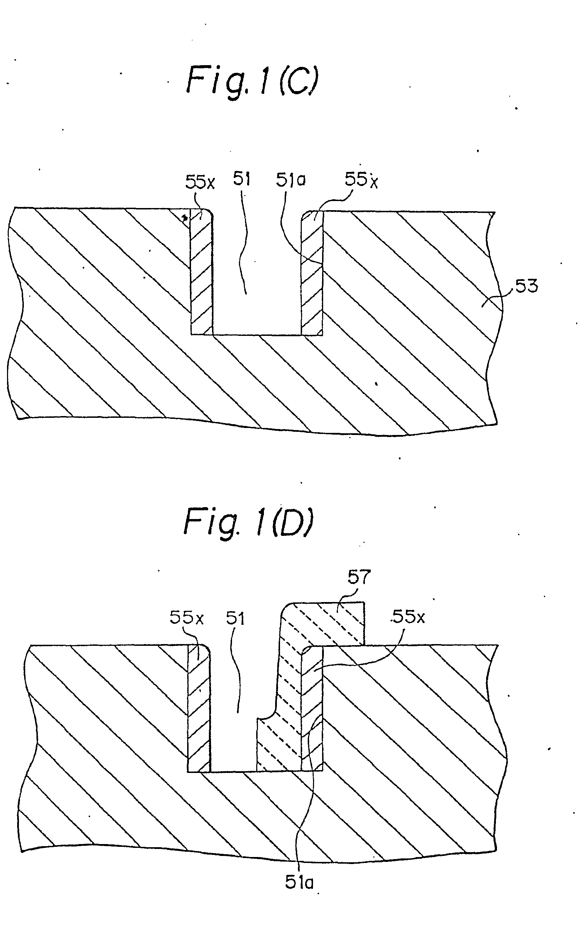

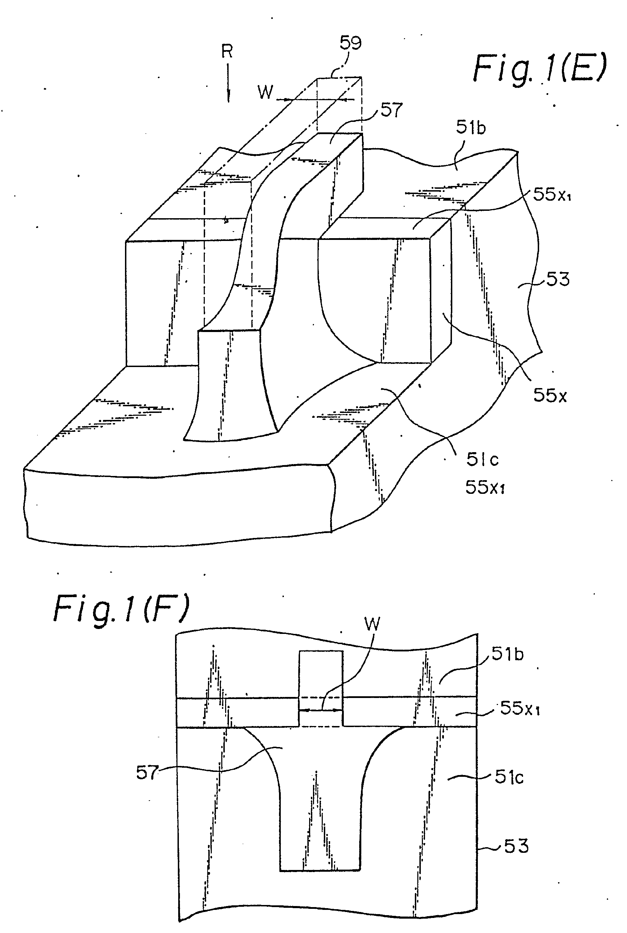

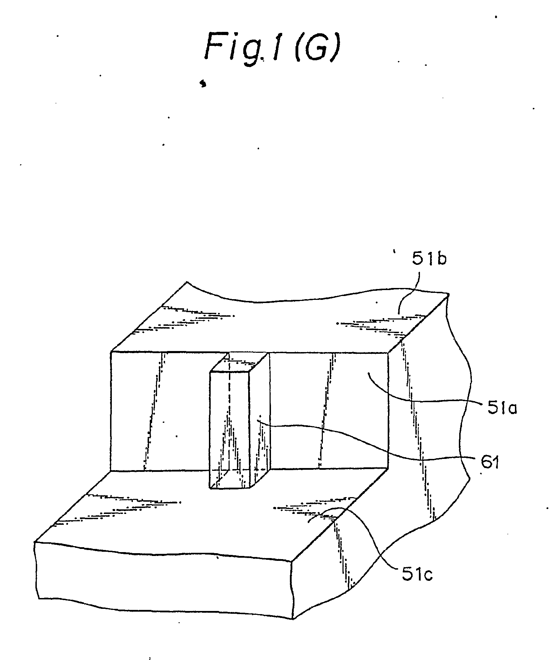

Figs. 1(A) - (G) are, respectively, illustrative views of an embodiment of a pattern formation method according to the invention and are a flow chart wherein a semiconductor substrate 53 having a recess 51 as shown in Fig. 1(A) is formed with a film pattern (not shown in Fig. 1(A)) on one side wall 51a of a step in the recess 51. Figs. 1(A) - (D) of these figures are, respectively, sectional views of the semiconductor substrate 53 cut away along the direction intersecting with the side wall 51a, Figs. 1(E) and (F) are, respectively, perspective views of the side wall 51a as viewed from an oblique direction, and Fig. 1(F) is a plan view of the semiconductor substrate 53 as viewed from above. In this embodiment, the semiconductor substrate 53 includes, for example, a silicon substrate and other various semiconductor substrates such as gallium arsenic and the like. The film pattern formed on the side wall 51a in this embodiment includes, for example, a wiring pattern or a gate electrode of MOS transistor. The materials for the film used to form the film pattern (not shown in Fig. 1(A)) includes polysilicon, high melting metals such as tungsten and the like, or silicides when the wiring or gate electrode is taken into account for use as the film pattern. The depth of the recess 51 will depend on the structure and the degree of integration of a semiconductor device to be formed and is not critical unconditionally, and is generally in the range of 1 - 5 m. The embodiment of the pattern formation method is described in the order of the steps.

Initially, a film 55 of material used to form a film pattern is formed over the entire surface of the semiconductor substrate 53 including the recess 51 (step). In this embodiment the material film 55 is deposited on the semconductor substrate 53 according to an appropriate film formation technique which depends on the type of material (Fig. 1(B)).

Next, the material film 55 is removed by anisotropic etching except for portions of the side walls (all the side walls including the side wall 51a) of the step of the material film 55. This is carried out in this embodiment by etching the material film 55 from the above of the semiconductor substrate 53 according to the RIE method (Fig. 1(C)). In Fig. 1(C), reference numeral 55x indicates portions the material film 55 left on the side walls. This portion is hereinafter referred to as side wall film 55x.

Thereafter, a given mask layer is formed in position of the side film 55x extending from an upper portion to a lower portion of the step. This is performed in the following manner in this embodiment. First, a positive resist is applied over the entire surface of the semiconductor substrate 53 including the recess 51. The resist is exposed to light and developed so that it remains on a portion of the side wall 51a on which the side wall film 55x is formed, thereby forming a resist pattern 57 used as a mask layer (Fig. 1(D)). Fig. 1(E) is a perspective view showing the resist pattern 57 as viewed at a position where the side wall 51a is seen from an oblique direction and Fig. 1(F) is a plan view of the resist pattern 57 as viewed from the above of the semiconductor substrate 53 (or from the direction of R in Fig.

9

1(E)). From these figures, it will be apparent that the resist pattern 57 faithfully follows the shape of the mask pattern on the upper portion 51b of the step and on one end $55x_1$ of the side wall film 55 on the wall face 51a or on the same plane as the upper portion 51b of the step, but is completely different from the shape of the mask pattern 59 in the other portions. It will be noted that the reason why the shape of the reist pattern 57 at the lower portion 51c of the step is far away from the shape of the mask pattern 59 is similar to as illustrated with reference to Figs. 6(B) and (C) and is not again described.

Subsequently, the side wall film 55x is selectively removed through the mask of the resist pattern 57. In this embodiment, the selective removal of the side wall film 55x is performed by similar anisotropic etching as used to remove the portions other than the side wall film 55x of the material film. In this anisotropic etching, the side wall film 55x is removed from one end $55x_1$, of the side wall film shown in Fig. 1(F) toward the lower portion 51c of the step, so that the side wall film 55x remains only at a portion corresponding to a portion with a width of W of the resist pattern 57. As a consequence, there is obtained a film pattern 61 shown in Fig. 1(G).

The thus obtained film pattern 61 can be effectively utilized, for example, as a wiring or a gate electrode for MOS transistor.

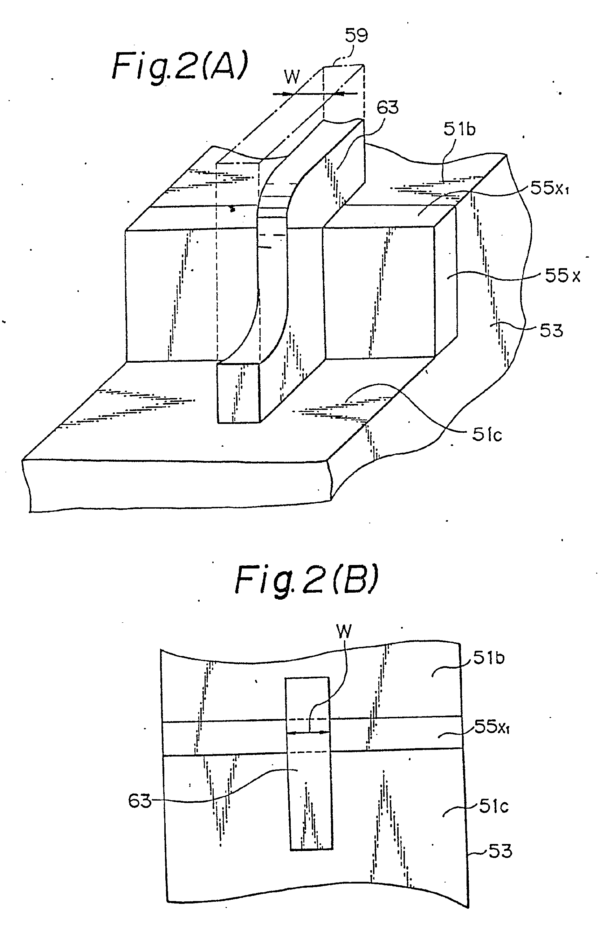

In case the mask layer which is formed in position of the side wall film 55x as extending from the upper portion 51b of the step to the lower portion 51c is a resist pattern 63 which is faithful to a mask pattern 59 at the lower portion 51c of the step as will be described with reference to Figs. 2(A) and (B), the selective removal of the side wall film 55x may be effected

10

by a technique other than the anisotropic etching, such as, for example, wet etching.

In the above embodiment, the side wall of the recess 51 of the semiconductor substrate 53, i.e. the side wall of the step, is illustrated as a side wall which is vertical to the plane of the upper portion of the step (i.e. the main plane of the substrate). However, even though the recess is tapered or vice versa, the present invention is likewise applicable provided that the angle between the main plane of the substrate and the side wall is within a range of a taper angle which permits anisotropic etching.

DESCRIPTION OF THE USE OF THE INVENTION

In order to facilitate better understanding of the pattern formation method according to the invention, the application of the film pattern formed according to the method is described.

<Application Example 1>

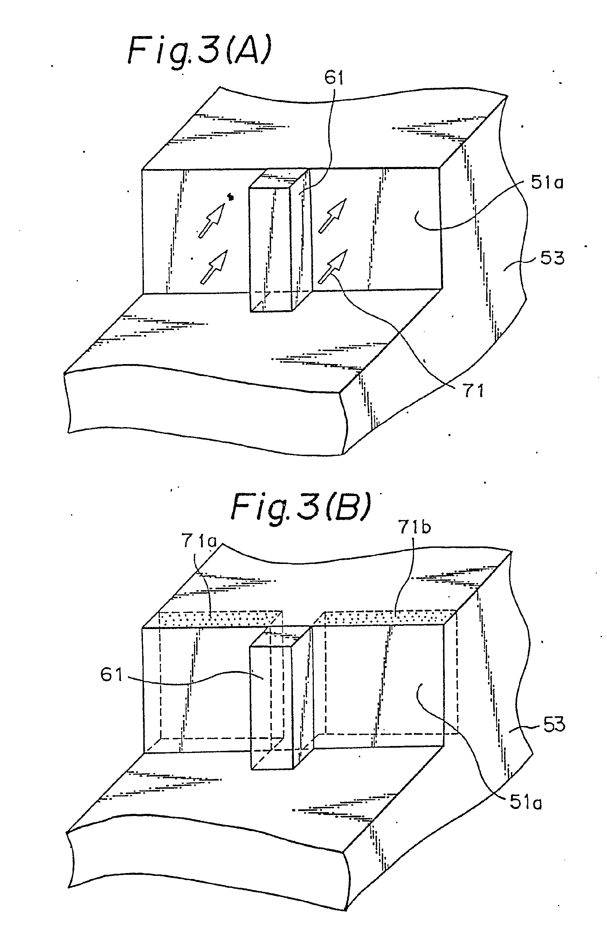

Figs. 3(A) and (B) show an example wherein a film pattern 61 formed by the method illustrated with reference to Figs. 1(A) to 1(G) was used as a mask and ions (71 indicated by the arrows in Fig. 3(A)) were incorporated in the side wall 51a of the step such as by ion injection of ion diffusion, thereby forming reactive layers 71a, 71b which were, for example, source drain regions of MOS transistor. In this manner, the MOS transistor can be readily formed at the side walls.

<Application Example 2>

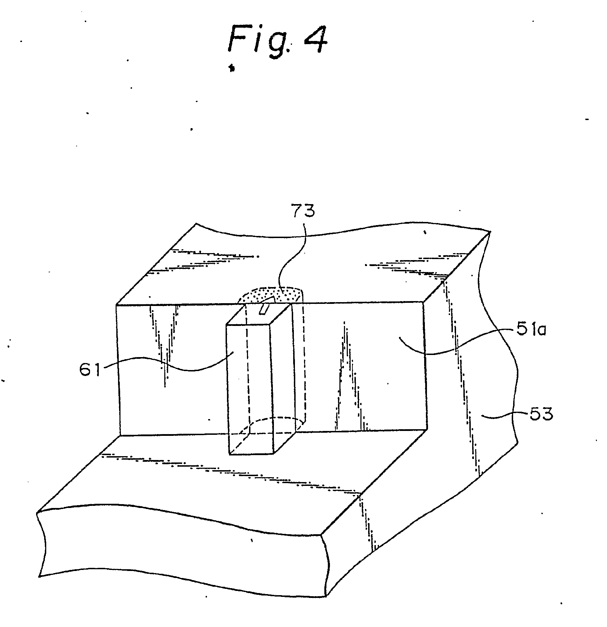

Fig. 4 shows an example wherein an impurity was diffused from the film pattern 61 formed by the method illustrated with

11

reference to Figs. 1(A) - 1(G) toward the side wall 51a to form a reactive layer 73 or an example wherein the material for the film pattern 61 and the semiconductor substrate are reacted at the contact portion thereof to form a reactive layer 73. In this manner, there can be readily formed, for example, a silicide layer in the side wall 51a.

INDUSTRIAL UTILITY

As will be apparent from the foregoing, the pattern formation method according to the invention can mitigate the precision for mask alignment since there is no material film at the upper and lower portions of a step over the entire surface of base.

Since the mask layer has a shape which is completely different from a desired shape at the lower portion of the step, a desired film pattern can be obtained, permitting a known simple resist process to be used for this purpose.

Accordingly, a given pattern can be simply formed on side walls of the step.

CLAIMS

(1)  A pattern formation method wherein a base having a step is formed with a film pattern on a side wall of the step, characterized by comprising:

the step of forming a film of a material used to form said film pattern over the entire surface of the base including the surface of said step;

the step of removing the material film by anisotropic etching from portions other than the side wall of said step;

the step of forming a mask layer in position of a remaining portion of said material film on said side wall while extending from an upper portion to a lower portion of said step; and

the step of selectively removing the remainin portion of said material film on said side wall through the mask layer used as a mask.

(2)  A pattern formation method according to Claim 1, characterized in that the selective removal of the remaining portion of said material film on said side wall is performed by anisotropic etching from the above of the base surface.

## Fig. 1(A)

## Fig. 1(B)

## Fig. 1 (C)

## Fig. 1 (D)

Fig. 1(E)

Fig. 1(F)

# Fig.1 (G)

Fig.2(A)

Fig.2(B)

# Fig. 3(A)

# Fig. 3(B)

# Fig. 4

# Fig. 5

EP 0 402 482 A1

Fig. 6(A)

EP 0 402 482 A1

Fig. 6(B)

Fig. 6(C)

# Fig. 7(A)

# Fig. 7(B)

## Fig. 7(C)

## Fig. 7(D)

## Fig. 7(E)

43a

43b

35

37a

37b

## Fig. 7(F)

37a

33

37b

31

35

# INTERNATIONAL SEARCH REPORT

International Application No PCT/JP89/01260

## I. CLASSIFICATION OF SUBJECT MATTER (if several classification symbols apply, indicate all) °

According to International Patent Classification (IPC) or to both National Classification and IPC

Int. Cl$^5$    H01L21/302

## II. FIELDS SEARCHED

### Minimum Documentation Searched ⁷

| Classification System : | Classification Symbols |
|---|---|
| IPC | H01L21/302 |

### Documentation Searched other than Minimum Documentation to the Extent that such Documents are Included in the Fields Searched ⁸

| | |
|---|---|
| Jitsuyo Shinan Koho | 1965 - 1988 |
| Kokai Jitsuyo Shinan Koho | 1971 - 1988 |

## III. DOCUMENTS CONSIDERED TO BE RELEVANT ⁹

| Category * | Citation of Document, ¹¹ with indication, where appropriate, of the relevant passages ¹² | Relevant to Claim No. ¹³ |
|---|---|---|
| X | JP, A, 59-126661 (Nippon Telegraph & Telephone Corporation), 21 July 1984 (21. 07. 84), Page 4, lower right column, line 15 to page 5, upper left column, line 3, Figs. 23 to 24 (Family: none) | 1 |
| Y | JP, A, 62-97331 (Toshiba Corp.), 6 May 1987 (06. 05. 87), Page 1, lines 5 to 20 (Family: none) | 1 |
| A | JP, A, 63-99534 (Mitsubishi Electric Corporation), 30 April 1988 (30. 04. 88), Page 1, lower left column, line 5 to lower right column, line 4, Fig. 1 (Family: none) | 1, 2 |

* Special categories of cited documents: ¹⁰

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| February 19, 1990 (19. 02. 90) | March 5, 1990 (05. 03. 90) |
| International Searching Authority | Signature of Authorized Officer. |
| Japanese Patent Office | |

Form PCT/ISA/210 (second sheet) (January 1985)